# EUROPEAN PATENT SPECIFICATION

(11) **EP 0 259 222 B1**
(45) Date of publication and mention of the grant of the patent: **24.03.1993**
(21) Application number: 87401933.4
(22) Date of filing: 26.08.1987
(51) Int. Cl.: H01L 23/50, H05K 3/20, H01L 21/58, H01L 21/60

(54) **Outer lead tape automated bonding system**
Automatisches Verbindungssystem mit Bändern von externen Anschlüssen
Système de liaison automatique par des rubans de connecteurs extérieurs

(30) Priority: 27.08.1986 US 900789
(43) Date of publication of application: 09.03.1988
(73) Proprietor: DIGITAL EQUIPMENT CORPORATION, Maynard, MA 01754 (US)
(72) Inventor: Hallowell, David L., Westford Massachusetts 01886 (US); Sofia, John W., Wakefield Massachusetts 01880 (US)
(74) Representative: Mongrédien, André

(56) References cited:
- EP-A- 0 016 522
- EP-A- 0 147 807
- EP-A- 0 213 014
- EP-A- 0 233 029
- DE-A- 3 219 055
- GB-A- 2 157 493
- US-A- 4 466 183
- IBM TECHNICAL DISCLOSURE BULLETIN, vol. 28, no. 5, October 1985, pages 2237-2238, Armonk, New York, US; "Outer lead guard bars for tab"
- IDEM
- PATENT ABSTRACTS OF JAPAN, vol. 9, no. 143 (E-322)[1866], 18th June 1985; & JP - A - 60 25263 (NIPPON DENKI K.K.) 08-02-1985

## Description

### Field of the Invention

This invention relates to a new method of bonding an integrated circuit chip to a substrate and more particularly to a new way of bonding the outer leads of a tape and integrated circuit chip sub-assembly to a substrate.

### Background of the Invention

One step in the process of manufacturing an integrated circuit component is packaging. In packaging, a fabricated semiconductor chip is housed in a protective package. The assembled component can be tested and connected to the electronic circuit for which it was designed. The package is provided with external leads so the component can be electrically connected to the electronic circuit.

A difficult part of the packaging process is connecting the chip to the package's external leads. Care must be taken to insure that each bond or connection point on the chip is properly connected to the appropriate external lead. Failure to make all of the proper connections will result in a malfunctioning or nonfunctioning component.

A current method of connecting the chip to the package leads is by Tape Automated Bonding (TAB). TAB employes a polyimide film tape having a plurality of individual tape sites. Each site comprises a support ring of film defining a center aperture. A plurality of conductive fingers formed by etching techniques, underly the support ring. Each conductive finger has an inner lead that extends into the center aperture and an outer lead that extends beyond the outer perimeter of the support ring. A chip is positioned over the aperture so that each bond point on the chip is in register with the appropriate inner lead. The bond points are then bonded to the inner leads.

The tape-and-chip lead sub-assembly is then excised from the tape. The sub-assembly is positioned on a package substrate so that the outer leads are aligned over appropriate package substrate leads which connect to package external leads of the package. Bonding of the outer leads to the substrate leads then connects the chip to the appropriate package external leads.

More thorough discussions of the Tape Automated Bonding process are set forth in Sze, edit., VLSI Technology, (1983) pp. 559-564, and in Dais, Erich, and Jaffe, "Face-Down TAB for Hybrids," IEEE Transactions on Components, Hybirds and Manufacturing Technology (Dec. 1980) pp. 623-633, which are incorporated herein by reference.

Tape Automated Bonding is an efficient way to connect semiconductor chips to packages. The tape sites can be arranged on the tape to allow for automatic bonding of chips to the tape. By proper etching of the tape, the conductive fingers for each chip can be densely packed at the tape site. This feature is very important in the fabrication of Very Large Scale Integration (VLSI) chips, where often there are 100 to over 300 bonding points per chip.

However, it has proved difficult to align and bond the densely packed tape outer leads to the package substrate leads. There are three reasons for this; (1) curling forces in the leads are different along the tape in-line and across-the-line axes; (2) curling of the metal conductive fingers and the film on which they are etched is different and causes the leads of the sub-assembly to curl; and finally, (3) there is x-y sliding of the individual outer leads when a thermode bonding blade is pushed down on them. This curling and sliding make it difficult to keep the outer leads aligned prior to substrate bonding.

Outer lead curling and sliding also make it difficult to inspect the tape-and-chip sub-assembly prior to lead bonding. To prevent the outer leads from curling out of alignment, it is necessary to promptly bond the outer leads to the substrate leads. Any errors, such as fine misalignment, must be corrected by later inspection and rebonding.

These problems are relatively easy to correct and control when there are 10-100 outer leads per sub-assembly, and there is a lead pitch of more than 012 inch. However, VLSI sub-assemblies have 100 or more leads per sub-assembly. The outer leads are densely packed together, i.e., have a finer pitch between leads. As a result, it is very difficult to align and bond the tape outer leads of a VLSI TAB sub-assembly to package substrate leads. This has been a major obstacle to the efficient manufacture of VLSI components.

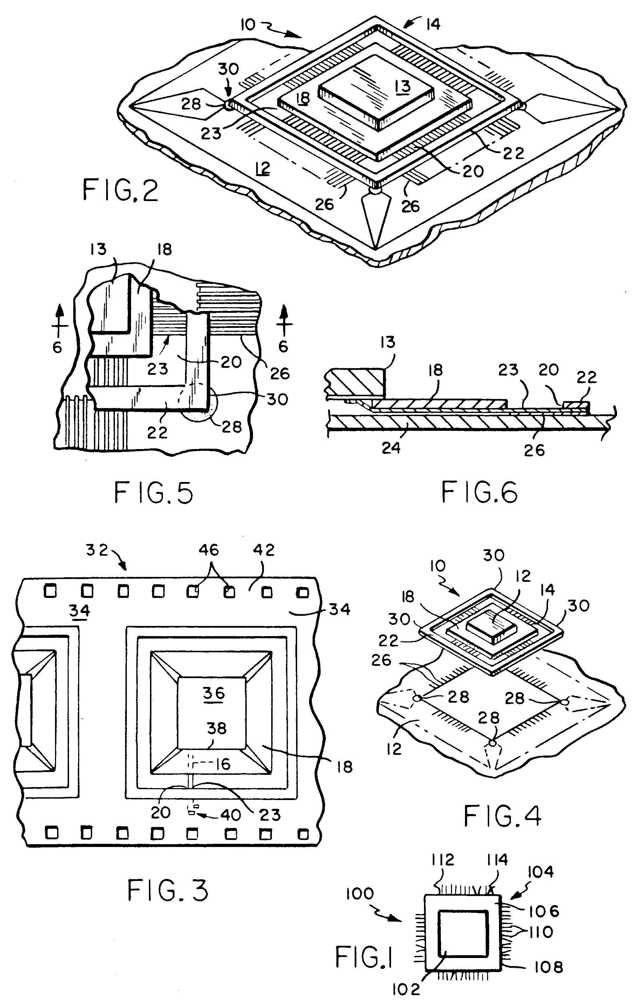

Fig.1 illustrates a prior art tape-and-chip sub-assembly 100. A chip 102 is bonded to a tape section 104. The tape section comprises a single support ring 106 that has a number of conductive fingers 108 etched on its underside. Each conductive finger has an outer lead 110 that extends beyond the outer perimeter of the support ring and inner leads (not shown) that underly and are bonded to the chip 102. The outer leads are not restrained, and in hadling, the individual leads may curl or become crossed as at 112 and 114, respectively. As a result, it is necessary to promtly bond the leads to a substrate without first inspecting and correcting for open, short, or misaligned leads. Furthermore, there is nothing to prevent individual outer leads from sliding out of position when a bonding tool is applied to connect the outer leads to the substrate leads.

We can also report on an other prior art constituted be the IBM Technical Disclosure Bulletin, vol.28, n^{o}5, october 1985, pages 2237 and 2238 which discloses a lead tape assembly and a method according to the preambles of claims 1 and 7.

A need, therefore, exists for a new method of bonding the outer leads of the conductive fingers of a tape-and-chip sub-assembly to the appropriate substrate leads. The new method should allow for the proper alignment of a large number of outer lead ends to the appropriate substrate leads, regardless of the density of the leads. The method should also prevent the curling of the outer leads prior to their being bonded to the substrate leads. Additionally, it should allow for the intermediate inspection of the sub-assembly after it is aligned on the substrate. This would allow for the correction of misalignment with the leads prior to bonding of the tape leads to the substrate. The new method of bonding should also prevent outer lead the sliding when a bonding tool is applied to bond a tape outer lead to a substrate lead.

### Summary of the Invention

In accordance with this invention each tape site is provided with an outer support ring of film over the ends of the outer leads. Each tape-and-chip sub-assembly has a ring of inner leads, an inner support ring, a ring of exposed outer leads, and an outer support ring adhered to the tips of the outer lead ends. The outer support ring restrains the outer lead ends from curling prior to their being bonded to a substrate.

The substrate is prepared for the sub-assembly by first applying deposits of hot, adhesive, viscous flux to the package substrate bonding pad. The substrate is heated so the flux remains adhesive. The tape-and-chip sub-assembly is positioned over the bonding pad in contact with the flux deposits and with the tape outer leads in register with the appropriate package substrate leads. Next, the substrate is cooled to harden the flux. The hardened flux binds the tape outer support ring to the substrate, and keeps the tape outer leads in register with the substrate leads.

This process makes it relatively easy subsequently to bond the tape outer leads to the substrate leads. In this respect the outer support ring serves two functions. Initially, it restrains the outer leads, in particular it prevents them from curling. Secondly, after the outer support ring is bonded to the substrate, it holds the outer leads in registration with the substrate leads. This provides an intermediate opportunity to thoroughly inspect the leads prior to bonding, since there is little possibility of the outer leads curling or otherwise coming out of alignment with the substrate leads. If any faults are detected, there is then an opportunity to correct them prior to the bonding operation. Since movement of the leads are restricted, it is a relatively easy task to use micro tools to correct any faults discovered.

The outer support ring also prevents the outer leads from sliding out of position when a bonding tool is applied to bond the leads to the substrate leads.

The foregoing process is especially suited to the manufacture of VLSI components.

### Brief Description of the Drawings

Figure 1 is a plan view of a tape-and-chip sub-assembly according to the prior art yet described.
Figure 2 is an isometric view of a tape-and-chip sub-assembly aligned on a package substrate according to the preferred embodiment of this invention;
Figure 3 is a plan view of a section of lead tape according to the preferred embodiment of this invention;
Figure 4 is an exploded isometric view illustrating the alignment of a tape-and-chip sub-assembly to a package substrate according to the preferred embodiment of this invention; and
Figure 5 is an enlarged plan view of a corner portion of the tape-and-chip sub-assembly of Fig 2;
Figure 6 is a cross-sectional view of the tape-and-chip sub-assembly taken along line 6-6 in Fig. 5;

### Detailed Description of the Preferred Embodiments

Figure 2 illustrates a tape-and-chip sub-assembly 10 bonded to a package substrate 12 according to this invention. The sub-assembly 10 comprises a semiconductor chip 13 bonded to an excised section of lead tape 14. A plurality of conductive fingers are etched on the underside of the lead tape 14. There is a sufficient number of fingers to make the necessary extended electrical connections between the chip 10 and the substrate 12. More specifically, the conductive fingers 16 extend out from a square-shaped inner support ring 18 of polyimide film extending around the semiconductor chip. Each conductive finger has a distally located outer lead 20. Over the ends of the outer leads is a square-shaped outer support ring 22, also of polyimide film. The inner perimeter of the outer support ring is spaced away from the outer perimeter of the inner support ring to expose portions 23 of the outer leads 20 therebetween.

The tape-and-chip sub-assembly 10 is located on a substrate mounting pad 24. Embedded on the substrate mounting pad 24 are substrate leads 26 that are connected to package external leads, (not shown). The sub-assembly is positioned over the substrate with each outer lead 20 portion over an appropriate substrate lead 26. The tape-and-chip sub-assembly is held to the substrate by deposits of flux 28 at the corners 30 of the outer support ring 22.

As best seen in Fig. 3, a tape 32 used in this process contains a plurality of individual tape sections 34 arranged serially. The conductive fingers 16 are etched on the undersides of the individual tape sections. The inner support ring 18 and the outer support ring are formed by etching so as to expose the portion 23 of outer leads 20 therebetween. A central aperture 36 is etched from the inner support ring to expose an inner lead 38 that extends from each conductive finger 16. Each conductive finger 16 extends beneath the inner support ring 18 and the outer support ring 22, and terminates in a test pad 40 located adjacent to the outer perimeter of the tape section 34. The tape 32 has sides 42 that are provided with sprocket holes 46.

The semiconductor chip 13 is mounted in the central aperture 36 of each tape section 34 according to standard TAB mounting practices. The sprocket holes 46 are provided so the tape can be mechanically advanced through a TAB chip bonding machine (not shown). During chip bonding, the inner leads 38 are connected to the appropriate bond points on the chip. The test pads 40 facilitate testing of the tape-and-chip connections after bonding. After inner lead bonding and testing, the tape-and-chip sub-assemblies 10 are excised from the tape 32 along the outer edges of the outer support ring 22.

The first step in bonding the tape-and-chip sub-assembly 10 to the substrate is to apply deposits of flux 28 to the substrate 12, as Figure 4 illustrates. The flux is applied on the substrate mounting pad 24 at locations where the outer support ring 22 is to be in contact with the substrate and where the outer leads 20 and substrate leads 26 are not to be bonded together. For example, this may be where the outer support ring corner regions 30 are over the substrate mounting pad 24, as Fig. 5 illustrates. The preferred type of flux 28 is a rosin-paste flux, from which the solvents, such as butyl carbitol and benzyl alcohol, have been evaporated. This results in a flux that is hard below 100°C and adhesive and viscous in the range of 120°C - 150°C. The flux is applied to the substrate at a temperature approximately 125°C. An automated "pogo pin/reservoir" system may be used to apply the flux to the substrate (not shown). The substrate is kept heated to approximately 125°C to insure that it remains adhesive but does not flow over the substrate.

The tape-and-chip sub-assembly 10 is then placed on the substrate 12. Using TAB assembly techniques the sub-assembly 10 is positioned so the outer leads 20 are in register with the appropriate substrate leads 26. After the sub-assembly 10 is properly aligned, the substrate is cooled to harden the flux 28 and thereby secure the outer ring 22 to the substrate in the proper position. The outer support ring 22, in turn, maintains the individual tape outer leads 20 in position, as Fig. 6 illustrates.

After the tape-and-chip sub-assembly 10 is flux-bonded to the substrate 12, the outer leads 20 can be inspected. Since the outer leads are restrained from moving, the bonded assembly can be thoroughly inspected for openings, shorts, and fine misalignments. Any defects can be repaired by a warm probe. After the assembly has been inspected and, if necessary repaired, the tape outer leads can then be bonded to the substrate leads using standard micro-bonding techniques. During the outer lead bonding process the outer support ring prevents the outer leads from sliding when the bonding tool is applied. The assembly is then available for the final steps of the packaging process.

The method of alignment and bonding of this invention is especially suited to the manufacture of VLSI components. The outer support ring can restrain the movement of any number of individual outer leads. Flux bonding the tape-and-chip sub-assembly to the substrate keeps the outer leads aligned during the inspection and lead bonding process. This significantly reduces the amount of effort required to bond the outer leads to a substrate, even though the leads may be densely packed together. These features are important when manufacturing a VLSI component that has a large number of leads in a small space.

## Claims

1. A method of bonding a lead tape-and-chip sub-assembly (10) to a package substrate (12), the lead tape (14) having a plurality of conductive fingers (16) electrically connected to the chip (13), each conductive finger (16) having an outer lead (20) that has an inner portion extending from an electrically insulating inner support ring (18) and an outer end that is distally located from the chip (13), the method comprising the steps of:
A. providing the tape-and-chip sub-assembly (10) with an electrically insulating tape outer support section secured to the outer ends of the outer leads (20) so as to restrict the movement of individual outer leads (20); and
B. positioning the tape-and-chip sub-assembly (10) with respect to the package substrate (12) so that each individual tape outer lead (20) is in registration with the associated substrate lead (26) on the package substrate (12);
**characterized** by the steps of
C. providing the tape outer support section as an outer support ring (22) overlying and adhered to said outer ends of the outer leads (20);
D. bonding the outer support ring (22) to the package substrate (12) so as to restrain the movement of the outer leads (20) with respect to the associated substrate leads (26); and
E. after said outer-support-ring-bonding step, bonding the inner portions of the outer leads (20) to the associated substrate leads (26) on the package substrate (12).

2. The method of claim 1, wherein the outer support ring (22) is bonded to the package substrate (12) by applying an adhesive substance (28) between the tape outer support ring (22) and the package substrate (12) at at least one selected location.

3. The method of claim 2, wherein the adhesive substance (28) is a flux, the flux being hard below a first temperature and adhesive above a second temperature above the first temperature, and the tape outer support ring (22) is bonded to the package substrate (12) according to the steps of:
A. applying a flux deposit to at least one location on the package substrate (12) where the outer support ring (22) is to be positioned over the package substrate (12);
B. heating the flux above the second temperature so that the flux is adhesive;
C. positioning the tape-and-chip sub-assembly (10) so that each tape outer lead (20) is in registration with the associated substrate lead (26) and the outer support ring (22) is located in the flux; and
D. cooling the flux to below the first temperature so the flux hardens and thereby bonds the tape-and-chip sub-assembly (10) to the package substrate (12).

4. The method of claim 3, wherein the at least one selected location to which the flux deposit is applied is free of package substrate leads (26) and tape outer leads (20).

5. The method of claim 4, wherein the outer support ring (22) is a polygon, the tape outer leads (20) are spaced away from the corners (30) of the polygon, and at least one corner (30) of the polygon is located in the flux deposit.

6. The method of claim 3, wherein the flux is a resin-pasted flux with the solvents therein removed.

7. A lead tape assembly for electrically connecting a semi-conductor chip (13) to a substrate (12), the lead tape assembly comprising:
A. a plurality of conductive fingers (16) for electrically connecting bond points on the semi-conductor chip (13) to substrate leads (26) on the substrate (12), each conductive finger having an inner lead for bonding to a semi-conductor chip bond point, and an outer lead (20) distally located from the inner lead for bonding to a substrate lead (26);
B. an electrically insulating inner support ring (18) disposed on the conductive fingers (16) between said inner leads and said outer leads (20), said inner support ring (18) forming an aperture (36) for receiving the semi-conductor chip (13), said inner leads extending into said aperture (36); and
C. an electrically insulating outer support section disposed on respect to the ends of the outer leads (20) for restricting the movement of the individual outer leads (20);
**characterized** in that
D. said outer support section comprises an outer support ring (22); and
E. said lead tape assembly further comprises adhesive means (28) for securing said outer support ring (22) to said substrate (12) so that said outer leads (20) are at least temporarily maintained in registration with the substrate leads (26).

8. The lead tape assembly of claim 7, wherein said outer support ring (22) is spaced away from said inner support ring (18) so as to expose a portion (23) of said outer leads (20) therebetween.

9. The lead tape assembly of claim 7, wherein there is at least one location on said outer support ring (22) free of said outer leads (20).

10. The lead tape assembly of claim 8, wherein said outer support ring (22) is of a polygon shape having a plurality of corner regions (30).

11. The lead tape assembly of claim 10, wherein said outer leads (20) are spaced away from at least one corner region (30) of said outer support ring (22).

12. The lead tape assembly of claim 9, wherein said adhesive means (28) is disposed on said substrate (12) at locations along said outer support ring (22) free of said outer leads (20).

13. The lead tape assembly of claim 12, wherein said adhesive means (28) comprises a flux deposit.

14. The lead tape assembly of claim 11, wherein said adhesive means (28) secures said outer support ring (22) to said substrate (12) at said corner regions (30) of said outer support ring (22).

15. The lead tape assembly of claim 14, wherein said adhesive means (28) comprises a flux deposit on the substrate (12).

## Patentansprüche

1. Verfahren zum Verbinden einer Anschluß-Band/Chip-Untereinheit (10) auf einem Verpackungssubstrat (12), wobei das Anschluß-Band (14) eine Vielzahl von leitenden Fingern (16) hat, die elektrisch mit einem Chip (13) verbunden sind, wobei jeder leitende Finger (16) einen äußeren Anschluß (20) hat, welcher einen inneren Abschnitt hat, der von einem elektrisch isolierenden inneren Tragring (16) absteht, und ein äußeres Ende hat, das entfernt vom Chip (13) angeordnet ist, wobei das Verfahren die Schritte aufweist:
A. Versehen der Band/Chip-Untereinheit (10) mit einem elektrisch isolierenden äußeren Band-Tragabschnitt, der an den äußeren Enden der äußeren Anschlüsse (20) befestigt ist, so daß die Bewegung der einzelnen äußeren Anschlüsse (20) eingeschränkt wird; und
B. Positionieren der Band/Chip-Untereinheit (10) bezüglich dem Verpackungssubstrat (12), so daß jeder einzelne Bandaußenanschluß (20) in Ausrichtung mit dem zugeordneten Substratanschluß (26) auf dem Verpackungssubstrat (12) ist;
gekennzeichnet durch die Schritte:
C. Erzeugen des äußeren Band-Tragabschnitts als einen äußeren Tragring (22), der über den Enden der äußeren Anschlüsse (20) liegt und an diesen haftet;
D. Verbinden des äußeren Tragrings (22) mit dem Verpackungssubstrat (12), so daß die Bewegung der äußeren Anschlüsse (20) gegenüber den zugeordneten Substratanschlüssen (26) unterbunden ist; und
E. nach dem Außentragring-Verbindungsschritt, Verbinden der inneren Abschnitte der äußeren Anschlüsse (20) mit dem zugeordneten Substratanschluß (26) auf dem Verpackungssubstrat (12).

2. Verfahren nach Anspruch 1, worin der äußere Tragring (22) mit dem Verpackungssubstrat (12) verbunden wird, indem eine haftende Substanz (28) zwischen dem äußeren Band-Tragring (22) und dem Verpackungssubstrat (12) an zumindest einer ausgewählten Stelle aufgebracht wird.

3. Verfahren nach Anspruch 2, worin die haftende Substanz (28) ein Flußmittel ist, das unterhalb einer ersten Temperatur hart ist und oberhalb einer zweiten Temperatur haftend ist, welche über der ersten Temperatur ist, und worin der äußere Band-Tragring (22) mit dem Verpackungssubstrat (12) gemäß den folgenden Schritten verbunden wird:
A. Aufbringen einer Flußmittelschicht auf zumindest einer Stelle auf dem Verpackungssubstrat (12), wo der äußere Tragring (22) über dem Verpackungssubstrat (12) angeordnet werden soll;
B. Erwärmen des Flußmittels über die zweite Temperatur, so daß das Flußmittel haftend wird;
C. Positionieren der Band/Chip-Untereinheit (10), so daß jeder Bandaußenanschluß (20) in Ausrichtung mit dem zugeordneten Substratanschluß (26) ist und der äußere Tragring (22) im Flußmittel angeordnet ist; und
D. Abkühlen des Flußmittels unterhalb die erste Temperatur, so daß das Flußmittel hart wird und dadurch die Band/Chip-Untereinheit (10) mit dem Verpackungssubstrat (12) verbindet.

4. Verfahren nach Anspruch 3, worin zumindest eine ausgewählte Stelle, auf der die Flußmittelschicht aufgebracht wurde, frei von Verpackungssubstratanschlüssen (26) und Bandaußenanschlüssen (20) ist.

5. Verfahren nach Anspruch 4, worin der äußere Tragring (22) ein Polygon ist, die Bandaußenanschlüsse (20) von den Ecken (30) des Polygons beabstandet sind und worin zumindest eine Ecke (30) des Polygons in der Flußmittelschicht angeordnet ist.

6. Verfahren nach Anspruch 3, worin das Flußmittel eine Colophonium-Flußmittelpaste ist, aus der die Lösungsmittel entfernt sind.

7. Anschlußbandeinheit zum elektrischen Verbinden eines Halbleiterchips (13) mit einem Substrat (12), wobei die Anschlußbandeinheit aufweist:
A. eine Vielzahl von leitenden Fingern (16) zum elektrischen Verbinden von Bondpunkten auf dem Halbleiterchip (13) mit Substratanschlüssen (26) auf dem Substrat (12), wobei jeder leitende Finger einen inneren Anschluß zum Bonden auf einem Bondpunkt des Halbleiterchips und einen äußeren Anschluß (20), der von dem inneren Anschluß entfernt angeordnet ist, zum Bonden auf einen Substratanschluß (26) hat;
B. einen elektrisch isolierenden inneren Tragring (18), der auf den leitenden Fingern (16) zwischen dem inneren Anschluß und den äußeren Anschlüssen (20) angeordnet ist, wobei der innere Tragring (18) eine Öffnung (36) zum Aufnehmen des Halbleiterchips (13) bildet und die inneren Anschlüsse in die Öffnung (36) hineinreichen; und
C. einen elektrisch isolierenden äußeren Tragabschnitt, der auf den Enden der äußeren Anschlüsse (20) zum Einschränken der Bewegung der einzelnen Außenanschlüsse (20) angeordnet ist;
dadurch gekennzeichet, daß
D. der äußere Tragabschnitt einen äußeren Tragring (22) auweist; und
E. daß die Anschlußbandeinheit weiterhin ein Haftmittel (28) zum Besfestigen des äußeren Tragrings (22) auf dem Substrat (12) aufweist, so daß die äußeren Anschlüsse (20) Zumindest zeitweise in Ausrichtung mit den Substratanschlüssen (26) gehalten werden.

8. Anschlußbandeinheit nach Anspruch 7, worin der äußere Tragring (22) von dem inneren Tragring (18) beabstandet ist, so daß ein Abschnitt (23) der äußeren Anschlüsse (20) dort dazwischen freiliegt.

9. Anschlußbandeinheit nach Anspruch 7, worin zumindest eine Stelle auf dem äußeren Tragring (22) frei von den äußeren Anschlüssen (20) ist.

10. Anschlußbandeinheit nach Anspruch 8, worin der äußere Tragring (22) eine Polygonform mit einer Vielzahl von Eckenregionen (30) hat.

11. Anschlußbandeinheit nach Anspruch 10, worin die äußeren Anschlüsse (20) von zumindest einer Eckenregion (30) des äußeren Tragrings (22) entfernt sind.

12. Anschlußbandeinheit nach Anspruch 9, worin das Haftmittel (28) auf dem Substrat (12) an Stellen entlang dem äußeren Tragring (22), die frei von den äußeren Anschlüssen (20) sind, aufgetragen wird.

13. Anschlußbandeinheit nach Anspruch 12, worin das Haftmittel (28) eine Flußmittelschicht aufweist.

14. Anschlußbandeinheit nach Anspruch 11, worin das Haftmittel (28) den äußeren Tragring (22) auf dem Substrat (12) an den Eckenregionen (30) des äußeren Tragrings (22) befestigt.

15. Anschlußbandeinheit nach Anspruch 14, worin das Haftmittel (28) eine Flußmittelschicht auf dem Substrat (12) aufweist.

## Revendications

1. Méthode de liaison d'un sous-ensemble de bande et puce à fils conducteurs (10) à un substrat de boîtier (12), la bande à fils (14) comportant une pluralité de doigts conducteurs (16) connectés électriquement à la puce (13), chaque doigt conducteur (16) comportant un fil extérieur (20) qui a une partie intérieure s'étendant à partir d'une couronne de support intérieure (18) électriquement isolante et une extrémité extérieure qui est située à distance de la puce (13), la méthode comprenant les étapes qui consistent à:
A. munir le sous-ensemble de bande et puce (10) d'une portion de support extérieure de bande électriquement isolante, fixée aux extrémités extérieures des fils extérieurs (20) de manière à limiter le déplacement des fils extérieurs individuels (20); et à
B. positionner le sous-ensemble de bande et puce (10) par rapport au substrat de boîtier (12) de telle sorte que chaque fil extérieur de bande individuel (20) est aligné avec le fil de substrat associé (26) sur le substrat de boîtier (12);
caractérisée par les étapes qui consistent à:
C. fournir la portion de support extérieure de bande sous la forme d'une couronne de support extérieure (22) recouvrant et collée auxdites extrémités extérieures des fils extérieurs (20);
D. souder la couronne de support extérieure (22) sur le substrat de boîtier (12) de manière à empêcher le déplacement des fils extérieurs (20) par rapport aux fils de substrat associés (26); et
E. après ladite étape de soudage de la couronne de support extérieure, à souder les parties intérieures des fils extérieurs (20) aux fils de substrat associés (26) sur le substrat de boîtier (12).

2. Méthode selon la revendication 1, dans laquelle la couronne de support extérieure (22) est soudée au substrat de boîtier (12) en appliquant une substance collante (28) entre la couronne de support extérieure de bande (22) et le substrat de boîtier (12) à au moins un emplacement sélectionné.

3. Méthode selon la revendication 2, dans laquelle la substance collante (28) est un fondant, le fondant étant dur au-dessous d'une première température et collant au-dessus d'une seconde température supérieure à la première température, et la couronne de support extérieure de bande (22) est soudée au substrat de boîtier (12) selon les étapes qui consistent à:
A. appliquer un dépôt de fondant à au moins un emplacement sur le substrat de boîtier (12) où la couronne de support extérieure (22) doit être positionnée sur le substrat de boîtier (12);
B. chauffer le fondant au-dessus de la seconde température de telle sorte que le fondant est collant;
C. positionner le sous-ensemble de bande et puce (10) de telle sorte que chaque fils extérieur de bande (20) est aligné avec le fil de substrat associé (26) et la couronne de support extérieure (22) est placée dans le fondant; et à
D. refroidir le fondant jusqu'au-dessous de la première température de sorte que le fondant durcisse et souder ainsi le sous-ensemble de bande et puce (10) au substrat de boîtier (12).

4. Méthode selon la revendication 3, dans laquelle l'emplacement au moins sélectionné auquel le dépôt de fondant est appliqué ne comporte pas de fils de substrat de boîtier (26) et de fils extérieurs de bande (20).

5. Méthode selon la revendication 4, dans laquelle la couronne de support extérieure (22) est un polygone, les fils extérieurs de bande (20) sont espacés des angles (30) du polygone, et au moins un angle (30) du polygone est placé dans le dépôt de fondant.

6. Méthode selon la revendication 3, dans laquelle le fondant est un fondant de pâte de colophane dans lequel on a retiré les solvants.

7. Ensemble de bande et fils conducteurs pour connecter électriquement une puce à semiconducteurs (13) à un substrat (12), l'ensemble de bande et fils conducteurs comprenant:
A. une pluralité de doigts conducteurs (16) pour connecter électriquement des points de soudure sur la puce à semiconducteurs (13) à des fils conducteurs de substrat (26) sur le substrat (12), chaque doigt conducteur comportant un fil intérieur pour sa connexion à un point de soudure de puce à semiconducteurs, et un fil extérieur (20) situé à distance du fil intérieur pour sa connexion à un fil de substrat (26);
B. une couronne de support intérieure (18) électriquement isolante disposée sur les doigts conducteurs (16) entre lesdits fils intérieurs et lesdits fils extérieurs (20), ladite couronne de support intérieure (18) formant un trou (36) pour recevoir la puce à semiconducteurs (13), lesdits fils intérieurs s'étendant jusque dans ledit trou (36); et
C. une portion de support extérieure électriquement isolante disposée par rapport aux extrémités des fils extérieurs (20) pour limiter le déplacement des fils extérieurs individuels (20);
caractérisé en ce que
D. ladite portion de support extérieure comprend une couronne de support extérieure (22); et
E. ledit ensemble de bande et fils conducteurs comprend en outre un moyen collant (28) pour fixer ladite couronne de support extérieure (22) audit substrat (12) de telle sorte que lesdits fils extérieurs (20) sont au moins temporairement maintenus alignés avec les fils de substrat (26).

8. Ensemble de bande et fils conducteurs selon la revendication 7, dans lequel ladite couronne de support extérieure (22) est espacée de ladite couronne de support intérieure (18) de manière à exposer une partie (23) desdits fils extérieurs (20) entre celles-ci.

9. Ensemble de bande et fils conducteurs selon la revendication 7, dans lequel il y a au moins un emplacement sur ladite couronne de support extérieure (22) où lesdits fils extérieurs (20) ne sont pas présents.

10. Ensemble de bande et fils conducteurs selon la revendication 8, dans lequel ladite couronne de support extérieure (22) a la forme d'un polygone comportant une pluralité de régions d'angle (30).

11. Ensemble de bande et fils conducteurs selon la revendication 10, dans lequel lesdits fils extérieurs (20) sont espacés d'au moins une région d'angle (30) de ladite couronne de support extérieure (22).

12. Ensemble de bande et fils conducteurs selon la revendication 9, dans lequel ledit moyen collant (28) est disposé sur ledit substrat (12) à des emplacements le long de ladite couronne de support extérieure (22) où il n'y a pas lesdits fils extérieurs (20).

13. Ensemble de bande et fils conducteurs selon la revendication 12, dans lequel ledit moyen collant (28) est constitué par un dépôt de fondant.

14. Ensemble de bande et fils conducteurs selon la revendication 11, dans lequel ledit moyen collant (28) fixe ladite couronne de support extérieure (22) audit substrat (12) dans lesdites régions d'angle (30) de ladite couronne de support extérieure (22).

15. Ensemble de bande et fils conducteurs selon la revendication 14, dans lequel ledit moyen collant (18) est constitué par un dépôt de fondant sur le substrat (12).
